Europäisches Patentamt

European Patent Office

Office européen des brevets

(19)

(11) **EP 0 839 325 B1**

(12) **EUROPÄISCHE PATENTSCHRIFT**

(45) Veröffentlichungstag und Bekanntmachung des Hinweises auf die Patenterteilung:
**19.12.2001 Patentblatt 2001/51**

(21) Anmeldenummer: **96924747.7**

(22) Anmeldetag: **12.07.1996**

(51) Int Cl.⁷: **G01R 31/08**

(86) Internationale Anmeldenummer:
**PCT/DE96/01309**

(87) Internationale Veröffentlichungsnummer:
**WO 97/04325 (06.02.1997 Gazette 1997/07)**

(54) **MESSSCHALTUNG ZUM ERFASSEN UND ORTEN VON WASSEREINBRÜCHEN AN ROHR- ODER KABELANLAGEN**

MEASURING CIRCUIT FOR DETECTING AND LOCATING INCURSIONS OF WATER IN PIPE OR CABLE INSTALLATIONS

MONTAGE DE MESURE POUR LA DETECTION ET LA LOCALISATION D'ENTREES D'EAU DANS DES TUYAUX OU DES CABLES

(84) Benannte Vertragsstaaten:
**BE DE DK FR GB**

(30) Priorität: **18.07.1995 DE 19527972**
**15.11.1995 DE 19544391**

(43) Veröffentlichungstag der Anmeldung:
**06.05.1998 Patentblatt 1998/19**

(73) Patentinhaber: **PIRELLI CAVI E SISTEMI S.p.A.**
**20126 Milano (IT)**

(72) Erfinder:
• **GOEHLICH, Lothar**
**D-12109 Berlin (DE)**
• **GLAESE, Ulricke**
**D-30659 Hannover (DE)**

(74) Vertreter: **Koch, Thomas, Dr. et al**
**Hoffmann - Eitle Patent- und Rechtsanwälte**
**Arabellastrasse 4**
**81925 München (DE)**

(56) Entgegenhaltungen:
DE-A- 3 201 643       DE-A- 3 736 333
DE-A- 3 908 903       DE-A- 4 302 832

**Beschreibung**

Die Erfindung liegt auf dem Gebiet der Fehlerortung an Rohren und elektrischen Kabeln bzw. an mehradrigen Rohr- oder Kabelanlagen und befaßt sich mit der Ausgestaltung einer Meßschaltung, mit der ein Feuchtigkeitseinbruch in Rohre und Kabel bzw. Kabeladern erfaßt und geortet werden kann. Die Meßschaltung arbeitet dabei mit elektrischen Meßfühlern, die in den Rohren oder Kabeln bzw. Kabeladern angeordnet sind.

Zur Realisierung einer solchen Meßschaltung an einem geschirmten Starkstromkabel mit Kunststoffmantel ist es bekannt, längs der Schirmdrähte des Kabels bzw. der Kabelader einen Meßleiter anzuordnen, der in eine Ummantelung aus einem elektrisch isolierenden Material mit bei Feuchtigkeit gegenüber dem trockenen Zustand vermindertem Isoliervermögen eingebettet ist. Der Meßleiter kann dabei aus einer Widerstandslegierung bestehen. Dieser Meßleiter bildet zusammen mit einem nichtisolierten Leiter, bei dem es sich um geerdete Schirmdrähte handeln kann, einen Wassersensor, der zusammen mit einem Hilfsleiter, bei dem es sich um einen gegenüber dem Meßleiter feuchtigkeitsunempfindlich isolierten Leiter handelt, sowie mit einer Spannungsquelle und zwei veränderlichen Widerständen in eine Art Brückenschaltung einbezogen ist, in die noch ein Nullindikator eingeschaltet ist. Durch Nullabgleich kann ein Fehlerort ermittelt werden (DE 37 36 333 A1).

Bei einer anderen bekannten Meßschaltung wird als Meßleiter ein hochohmiger Leiter verwendet, der zusammen mit einem Schirmdraht einen Wassersensor in Form einer an einem Ende offene Meßschleife bildet. Am anderen Ende der Meßschleife ist ein Widerstandsmeßgerät angeordnet; mit Hilfe eines weiteren Meßgerätes und eines zusätzlichen, isolierten Leiters muß zuvor die mit einem Mantelfehler behaftete Kabelader ermittelt werden. Die Anwendung dieser Meßschaltung ist wegen der Gefahr betriebsmäßiger Überspannungen bei Starkstromkabelanlagen auf Kabellängen von max. 500 bis 1000 m beschränkt (DE 39 08 903 A1).

Zur Ortung von Wassereinbrüchen an Kabelanlagen größerer Länge ist weiterhin eine Meßschaltung bekannt, bei der als Meßleiter ebenfalls ein hochohmiger Leiter verwendet wird und bei der die aus Meßleiter und geerdetem Metalldraht bestehende Meßschleife am fernen Ende des Kabels über eine Diode geschlossen ist. Diese Meßschleife wird mit einem rechteckförmigen Wechselstrom sehr niedriger Frequenz beaufschlagt. Am Ende jeder Stromhalbwelle wird der in der Meßschleife fließende Strom gemessen; jeweils zwei aufeinanderfolgende Meßwerte werden einer Auswerteeinrichtung zugeführt. Diese Art der Fehlerortung muß bei mehradrigen Kabelanlagen für jede Kabelader gesondert durchgeführt werden (DE 43 02 832 A1).

Ausgehend von einer Meßschaltung mit den Merkmalen des Oberbegriffes des Patentanspruches 1 liegt der Erfindung die Aufgabe zugrunde, die Detektion und Ortung eines Wassereinbruches an Rohren und Kabeln zu vereinfachen und bei Kabelanlagen der Ausgestaltung der Meßschaltung im Hinblick auf das Auftreten von induzierten Spannungen Rechnung zu tragen.

Zur Lösung der allgemeinen Aufgabe ist vorgesehen, daß der Meßleiter und der Hilfsleiter am Ende des Rohres oder Kabels jeweils über einen Abschlußwiderstand auf einen gemeinsamen Belastungswiderstand geschaltet sind, der seinerseits mit dem nichtisolierten Leiter verbunden ist, und daß am Anfang des Rohres oder Kabels der Meßleiter und der Hilfsleiter jeweils mit einem Meßwiderstand beschaltet und die beiden Meßwiderstände und der nichtisolierte Leiter in beliebiger Kombination mit den beiden Polen einer Spannungsquelle verbunden sind oder beide Meßwiderstände mit dem nichtisolierten Leiter verbunden sind und der Meßleiter und der nichtisolierte Leiter innerhalb des Rohres oder Kabels die beiden Pole einer durch Feuchtigkeitseinwirkung aktivierbaren Spannungsquelle bilden.

Eine derart ausgebildete Meßschaltung sieht im wesentlichen vor, die beiden Leiter des elektrischen Wassersensors und den Hilfsleiter sowohl am Ende als auch am Anfang des Rohres oder Kabels so miteinander zu verkoppeln, daß ein Wassereinbruch mit einer einzigen Messung ohne Einstellung von Widerständen erfaßt und geortet werden kann. Während die Verkopplung der beiden Leiter des Wassersensors und des Hilfsleiters am Ende des Rohres oder Kabels für verschiedene Ausführungsformen der Meßschaltung immer dieselbe ist, kann die Verkopplung am Anfang des Rohres oder Kabels auf unterschiedliche Weise vorgenommen werden. Bei der direkten Verbindung der beiden Meßwiderstände des Meßleiters und des Hilfsleiters mit dem nichtisolierten Leiter müssen der Meßleiter und der nichtisolierte Leiter als Pole einer durch Feuchtigkeitseinwirkung aktivierbaren "inneren" Spannungsquelle ausgestaltet sein. Dies läßt sich vorteilhaft dadurch realisieren, daß der Meßleiter und der nichtisolierte Leiter aus dem gleichen elektrisch gut leitenden Metall bestehen und daß der Meßleiter mit einer maximal etwa 100 µm dicken Schicht aus einem Metall versehen ist, dessen elektrochemische Spannung kleiner ist als die des Leitermaterials. In diesem Fall bilden bei einem Wassereinbruch die Beschichtung des Meßleiters und der nichtisolierte Leiter im Bereich des Wassereinbruches ein galvanisches Element, dessen treibende Spannung und/oder dessen Strom am Anfang der Leiterschleife gemessen werden können. Aus einem Vergleich mit einer gleichartigen Messung in wenigstens einer weiteren, nicht durch einen Wassereinbruch verstimmten Leiterschleife kann mittels einer Rechenoperation die Entfernung der Schadensstelle vom Anfang der Leiterschleife ermittelt werden. - Um im Fall eines Wassereinbruches ein möglichst wirksames galvanisches Element vorliegen zu haben, sollten die elektrochemische Spannung des Beschichtungsmaterials und die elektrochemische Spannung des Leitermaterials auf der Skala der elektrochemischen Spannungsreihe der Elemente einen möglichst großen Abstand zueinander haben. Hierzu bestehen der Meßleiter und der nichtisolierte Leiter vorzugsweise aus Kupfer und die Beschichtung des Meßleiters aus Zink. Als ihr Isoliervermögen bei Zutritt von Wasser verringernde Isolierung kann beispielsweise ein Geflecht aus isolierenden Fäden verwendet werden. Diese Isolierung wird zweckmäßig auf den Meßleiter aufgebracht.

Bei Verwendung einer äußeren Spannungsquelle bei der Ausgestaltung der neuen Meßschaltung kann man nur den Meßwiderstand des Meßleiters oder nur den Meßwiderstand des Hilfsleiters direkt an den einen Pol der Spannungsquelle legen und den Meßwiderstand des jeweils anderen Leiters zusammen mit dem nichtisolierten Leiter an den anderen Pol der Spannungsquelle legen. In diesem Fall wird entweder der Meßleiter oder der Hilfsleiter gewissermaßen vom Kabelende her mit Spannung beaufschlagt; zum anderen kann man aber auch sowohl den Meßwiderstand des Meßleiters als auch den Meßwiderstand des Hilfsleiters gemeinsam an den einen Pol der Spannungsquelle und den nichtisolierten Leiter an den anderen Pol der Spannungsquelle legen. In jedem Fall ergibt sich in dem so gebildeten Widerstandsnetzwerk eine Stromverteilung, die im Fehlerfall von der normalen Stromverteilung charakteristisch abweicht und die an den Meßwiderständen erfaßt werden kann. Dabei gewährleisten die beiden Arbeitswiderstände, daß auch ein sehr dicht am Rohr- oder Kabelende auftretender Fehler sicher geortet werden kann. Sofern bei Rohren oder Kabeln aufgrund der Umgebungsbedingungen ausgeschlossen werden kann, daß im Endbereich des Rohres oder Kabels ein Feuchtigkeitseinbruch auftreten kann, kann der Widerstandswert des Arbeitswiderstandes gegen Null gehen, d.h. der Arbeitswiderstand kann entfallen.

Die neue Meßschaltung hat den weiteren Vorteil, daß sie auf einfache Weise auch auf mehradrige Rohr- oder Kabelanlagen, insbesondere auf dreiadrige Kabelanlagen erweitert werden kann. Bei Einsatz für zweiadrige Rohr- oder Kabelanlagen, bei denen also zwei Rohre oder Kabel parallel nebeneinander angeordnete sind, ist hierzu der dem Wassersensor des ersten Kabels zugeordnete Hilfsleiter in dem parallel zum ersten Rohr oder Kabel angeordneten zweiten Kabel oder Rohr anzuordnen und mit einer feuchtigkeitsempfindlichen Isolierung zu versehen, damit er in dem zweiten Kabel die Funktion eines Meßleiters wahrnehmen kann; dadurch, daß er innerhalb des zweiten, ummantelten Rohres oder Kabels angeordnet ist, bleibt er gegenüber dem Meßleiter des ersten Kabels feuchtigkeitsunempfindlich isoliert. Zusätzlich ist in dem zweiten Rohr oder Kabel ebenfalls ein nicht isolierter Leiter anzuordnen, der am Anfang und am Ende des zweiten Rohres oder Kabels mit dem nichtisolierten Leiter des ersten Rohres oder Kabels zu verbinden ist.

Bei Ausdehnung der Meßschaltung auf eine dreiadrige Rohroder Kabelanlage sind auch unter dem Mantel des dritten Rohres oder Kabels ein feuchtigkeitsempfindlicher Meßleiter und ein nichtisolierter Leiter anzuordnen; dieser dritte Meßleiter ist am Anfang des dritten Rohres oder Kabels ebenfalls mit einem Meßwiderstand zu beschalten und am Ende des Rohres oder Kabels mit einem Abschlußwiderstand zu beschalten und dieser Abschlußwiderstand ist auf den gemeinsamen Belastungswiderstand der beiden anderen Rohre oder Kabel zu schalten, wobei der nichtisolierte Leiter des dritten Kabels am Anfang und am Ende des Rohres oder Kabels mit den nichtisolierten Leitern der beiden anderen Rohre oder Kabel zu verbinden ist; weiterhin ist der Meßwiderstand des dritten Meßleiters ebenfalls mit einem der beiden Pole der Spannungsquelle bzw. mit dem nichtisolierten Leiter zu verbinden.

Aus meßtechnischen Gründen ist es sinnvoll, den bzw. die nichtisolierten Leiter am Anfang und/oder am Ende des Rohres oder Kabels bzw. der Rohr- oder Kabelanlage zu erden. In diesem Fall können bei elektrischen Kabelanlagen die Schirmdrähte des jeweiligen Kabels als nichtisolierter Leiter fungieren.

Bei Einsatz der neuen Meßschaltung an mehradrigen Kabelanlagen, insbesondere an Hochspannungskabelanlagen, ist zusätzlich zu berücksichtigen, daß die Wassersensoren und damit auch der meßtechnische Zugang zur Kabelanlage möglichst gegen das Auftreten unzulässig hoher induzierter Wechselspannungen, die im Betrieb der Kabelanlage ihre Ursache haben, zu schützen sind. Dem wird zum Teil schon dadurch Rechnung getragen, daß jeder Meßleiter mit einem Abschlußwiderstand beschaltet ist, dessen Widerstandswert zweckmäßig etwa 20 % des Widerstandswertes des Meßleiters beträgt. Dabei wird für den Meßleiter zweckmäßig ein Leiter mit einem Widerstandswert zwischen 0,01 und $10^3$ Ohm/m gewählt. Als weitere Maßnahme sollte am Anfang und am Ende jeder Kabelader zwischen dem Meßleiter und dem nichtisolierten Leiter jedes Wassersensors ein Überspannungsableiter geschaltet sein. Bei einer Meßschaltung, die die Einspeisung derselben Spannung in alle Meßleiter vorsieht, sollte weiterhin zwischen den Meßwiderständen und der Spannungsquelle ein Relais angeordnet sein und ein Ruhekontakt dieses Relais die Meßwiderstände mit den nichtisoslierten Leitern der Wassersensoren verbinden. Dadurch wäre gewährleistet, daß die Meßleiter am Anfang der Kabelstrecke jederzeit entweder über die Spannungsquelle niederohmig oder über die Relaiskontakte direkt wechselspannungsmäßig geerdet sind. - Bei Hochspannungskabelanlagen mit ausgekreuzten Kabelmänteln ist darauf zu achten, daß die Meßleiter ebenfalls ausgekreuzt werden.

Die für die Durchführung des neuen Meßverfahrens erforderlichen Bauteile (im wesentlichen Widerstände) können an den Enden der Kabeladern entweder direkt auf den Kabeladern und/oder in einem Gehäuse angeordnet werden. Dadurch entfallen besondere Verbindungsleitungen und es wird dem gewohnten Anlagenbau Rechnung getragen.

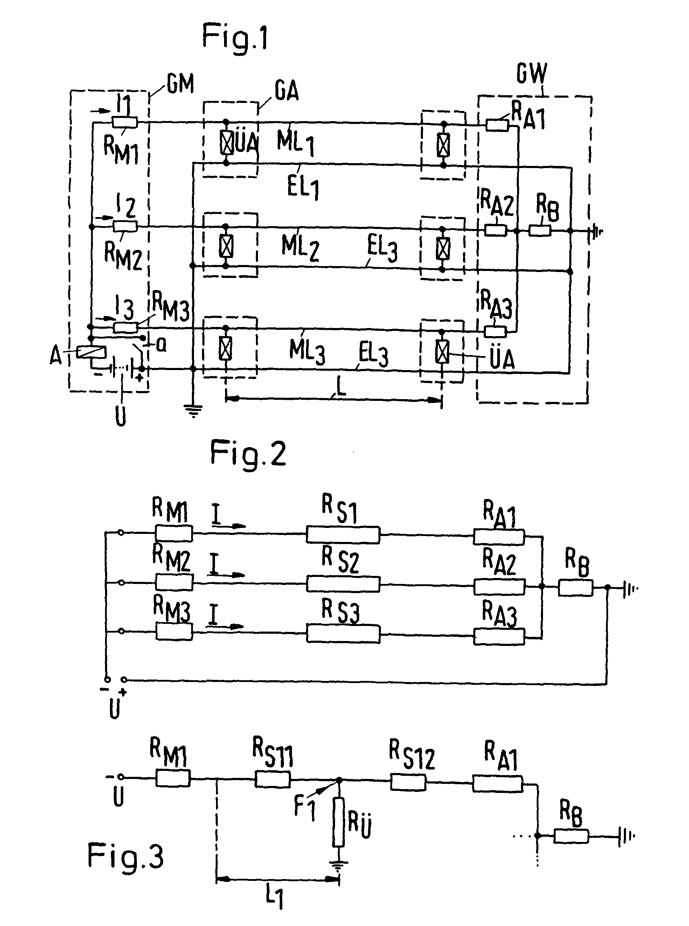

Mehrere Ausführungsbeispiele von Meßschaltungen zur Durchführung des neuen Meßverfahrens sind in den Figuren 1 bis 12 dargestellt. Dabei zeigt

| Figur 1 | eine Meßschaltung, bei der die Meßleiter einer dreiadrigen Kabelanlage parallel mit derselben Meßspannung beaufschlagt werden, |
|---|---|
| Figur 2 | ein für die eigentliche Messung relevantes Ersatzschaltbild der Meßschaltung gemäß Figur 1 und |
| Figur 3 | die Veränderung des Ersatzschaltbildes gemäß Figur 2 bei Auftreten eines Wassereinbruches. Weiterhin zeigt |
| Figur 4 | eine Meßschaltung, bei der jeweils ein Meßleiter einer dreiadrigen Kabelanlage an eine Meßspannung gelegt und die anderen Meßschleifen am meßseitigen Ende kurzgeschlossen werden, |
| Figur 5 | ein für die meßtechnischen Belange relevantes Ersatzschaltbild der Meßschaltung gemäß Figur 2 und |
| Figur 6 | die Veränderung des Ersatzschaltbildes gemäß Figur 5 bei Auftreten eines Wassereinbruches. |
| Figur 7 | eine Meßschaltung für ein ein- oder dreiadriges Kabel mit einem feuchtigkeitsunempfindlich isolierten Hilfsleiter gemäß Patentanspruch 1, |
| Figur 8 | eine Variante der Meßschaltung gemäß Figur 7 am Anfang des Kabels, |
| Figur 9 | eine Meßschaltung für ein ein- oder mehradriges elektrisches Kabel, bei dem der Meßleiter und der nichtisolierte Leiter eine durch Feuchtigkeitseinwirkung aktivierbare Spannungsquelle gemäß Patentanspruch 1 bilden, |
| Figur 10 | eine Erweiterung der Meßschaltung gemäß Figur 7 für eine zweiadrige Kabelanlage, |
| Figuren 11 und 12 | zwei Varianten der Meßschaltung gemäß Figur 5, wobei die Variationen den am Anfang der Kabelanlage liegenden Teil der Meßschaltung betreffen. |

In den Figuren 1 bis 12 werden die einzelnen Schaltungselemente mit Buchstaben bzw. Buchstabenkombinationen bezeichnet, deren Bedeutung nachfolgend aufgeführt ist:

| L | Länge eines Kabels oder einer zwei- bzw. dreiadrigen Kabelanlage |
|---|---|
| $L_1$ | Abstand der Schadenstelle vom Anfang der Kabelanlage |
| $F_1$ | Ort eines Wassereinbruches, Schadenstelle |
| ML | der in jedem Kabel oder jeder Kabelader im Schirmbereich angeordnete Meßleiter eines Wassersensors |
| HL | der in einem ein- oder mehradrigen Kabel angeordnete Hilfsleiter |
| EL | der in jedem Kabel oder jeder Kabelader im Schirmbereich angeordnete nichtisolierte, geerdete Leiter des Wassersensors, z. B. ein Schirmdraht |
| $R_M$ | der jedem Meßleiter vorgeschaltete Meßwiderstand |
| $R_S$ | Gesamtwiderstand der einzelnen Meßleiter, mit $R_S'$ = längenspezifischer Widerstand |
| $R_H$ | Widerstand des Hilfsleiters |
| $R_A$ | Abschlußwiderstande, mit denen die Meßleiter der Wassersensoren beschaltet sind |
| $R_B$ | ein allen Meßleitern gemeinsamer Belastungswiderstand |
| ÜA | die am Anfang und am Ende jeder Kabelader angeordneten Überspannungsableiter |
| GA | Gehäuse für die Überspannungsableiter |
| GW | am Ende der Kabelanlage angeordnetes Gehäuse zur Aufnahme der Widerstände $R_A$ und $R_B$ |
| U | eine äußere Spannungsquelle |
| $U_i$ | eine innere Spannungsquelle |
| A,B,C | ein Relais mit den Ruhekontakten a, b und c |
| I | Strom durch den Meßwiderstand eines Meßleiters |

Unter Berücksichtigung dieser Bezeichnungen und ihrer Bedeutungen zeigt Figur 7 in Anlehnung an die Meßschaltung gemäß DE 37 36 333 eine Meßschaltung, bei der in einem beispielsweise dreiadrigen Kabel der Länge L ein Meßleiter $ML_1$, ein Hilfsleiter HL und ein nichtisolierter, geerdeter Leiter $EL_1$ entweder in den Zwischenräumen oder im Schirmbereich angeordnet sind. Der Widerstand des Meßleiters ist dabei mit $R_{S1}$ und der Widerstand des Hilfsleiters $R_{S2}$ bezeichnet. Sowohl dem Meßleiter als auch dem Hilfsleiter ist jeweils ein Meßwiderstand $R_{M1}$ bzw. $R_{M2}$ vorgeschaltet; beide Meßwiderstände sind gemeinsam an den einen Pol einer Spannungsquelle U gelegt. - Sowohl dem Meßleiter als auch dem Hilfsleiter ist jeweils ein Arbeitswiderstand $R_{A1}$ bzw. $R_{A2}$ nachgeschaltet, wobei beide Arbeitswiderstände auf einen Belastungswiderstand $R_B$ geschaltet sind. Dieser Belastungswiderstand ist weiterhin mit dem nichtisolierten, geerdeten Leiter $EL_1$ verbunden, der seinerseits an den anderen Pol der Spannungsquelle geschaltet ist. Bei dieser Spannungsquelle kann es sich um eine Gleichspannungsquelle oder um eine recheckförmige Wechselspannungsquelle sehr niedriger Frequenz handeln.

Jedem Meßwiderstand $R_{M1}$ bzw. $R_{M2}$ ist ein nicht näher dargestelltes Strommeßgerät zugeordnet, mit dem die Ströme $I_1$ und $I_2$ gemessen werden. Bei Auftreten eines Mantelfehlers, der mit einem Wassereinbruch verbunden ist, an einer Schadenstelle $F_1$ in einer Entfernung $L_1$ vom Anfang der Kabelanlage bildet sich an der Schadensstelle ein Übergangswiderstand zwischen dem Meßleiter $ML_1$ und dem geerdeten Leiter $EL_1$, wodurch die Stromverteilung

4

über die Meßwiderstände $R_{M1}$ und $R_{M2}$ verändert wird. Aus dem dann vorliegenden Widerstandsnetzwerk mit den bekannten Widerständen und den gemessenen Strömen kann der Fehlerort errechnet werden. Dies erfolgt zweckmäßig mit Hilfe eines entsprechend programmierten Mikrochips im Meßgerät.

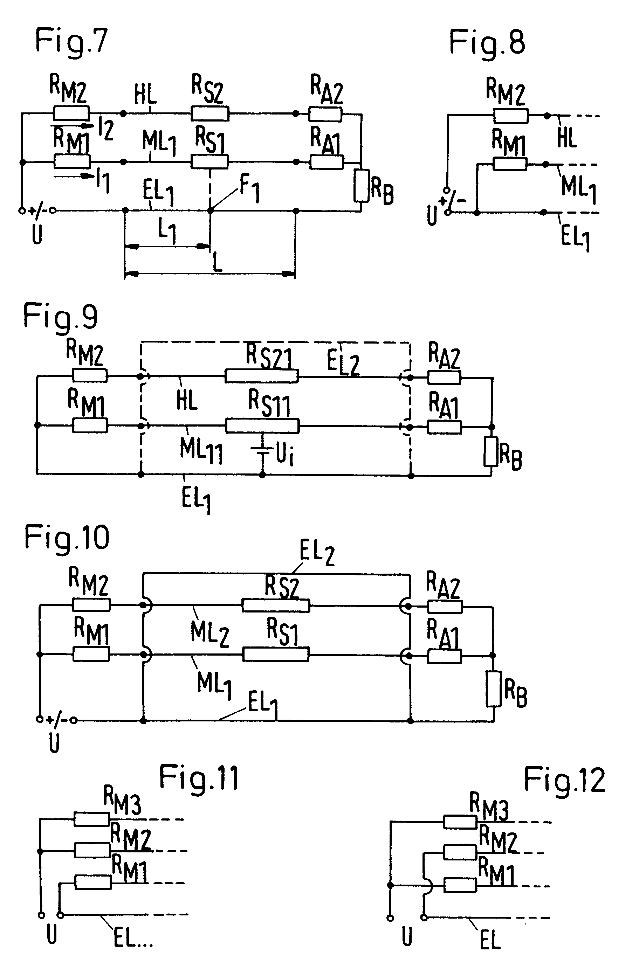

Gemäß Figur 8 kann die Meßschaltung am Anfang des Kabels auch so ausgebildet sein, daß nur der Meßwiderstand $R_{M2}$ gegen den einen Pol der Spannungsquelle und der Meßwiderstand $R_{M1}$ gemeinsam mit dem nichtisolierten Leiter $EL_1$ gegen den anderen Pol der Spannungsquelle geschaltet wird. Alternativ können die Anschlüsse der beiden Meßwiderstände vertauscht werden.

Figur 9 zeigt eine Meßschaltung, bei der der Meßleiter $ML_{11}$ und der nichtisolierte, geerdete Leiter $EL_1$ dadurch eine potentielle galvanische Spannungsquelle bilden, daß der Meßleiter als Kupferleiter mit einer etwa 100 μm dicken Schicht aus Zink ausgebildet und mit einem Geflecht aus isolierenden Fäden versehen ist. Detaillierte Erläuterungen bezüglich dieser Ausgestaltung des Meßleiters sind der deutschen Patentanmeldung P 195 27 972.7 zu entnehmen. - Der gegenüber dem Meßleiter $ML_{11}$ feuchtigkeitsunempfindlich isolierte Hilfsleiter HL ist dagegen als normaler elektrischer Leiter ausgebildet. Im Falle eines Feuchtigkeitseinbruches entsteht so innerhalb des Kabels eine Spannungsquelle $U_i$, die zu Strömen über die beiden Meßwiderstände $R_{M1}$ und $R_{M2}$ führt, wenn diese am Anfang des Kabels gemeinsam mit dem nichtisolierten Leiter $EL_1$ verbunden und am Ende des Kabels über jeweils einen Arbeitswiderstand $R_{A1}$ bzw. $R_{A2}$ und einen gemeinsamen Belastungswiderstand $R_B$ ebenfalls mit dem nichtisolierten Leiter $EL_1$ verbunden sind.

Die Schaltung gemäß Figur 9 ist auch für zweiadrige Kabelanlagen anwendbar, wenn der Hilfsleiter HL im zweiten Kabel angeordnet und als Meßleiter ausgebildet ist und demzufolge mit dem dort zusätzlich angeordneten nichtisolierten, geerdeten Leiter $EL_2$ ebenfalls eine potentielle galvanische Spannungsquelle bildet. Der im zweiten Kabel angeordnete Leiter $EL_2$ ist am Anfang und am Ende der Kabelanlage mit dem nichtisolierten Leiter $EL_1$ des ersten Kabels zu verbinden, wie es gestrichelt in der Figur dargestellt ist.

Die Meßschaltung gemäß Figur 9 kann auch auf dreiadrige Kabelanlagen erweitert werden, wenn in der dritten Kabelader ebenfalls ein entsprechender Meßleiter und ein nichtisolierter Leiter angeordnet werden und der Meßleiter und der geerdete, nichtisolierte Leiter gemäß Patentanspruch 3 in die Meßschaltung einbezogen werden.

Bei Ausgestaltung des Meßleiters und des nichtisolierten Leiters als durch Feuchtigkeitseinwirkung aktivierbare Spannungsquelle arbeitet das galvanische Element im Falle eines Wassereinbruches solange, bis in dem mit Wasser verunreinigten Bereich der Kabelader die Zinkschicht des Meßleiters abgetragen ist. Dieser Zeitraum kann in Abhängigkeit von der Dicke der Zinkschicht beispielsweise 5 bis 10 Tage betragen.

Figur 10 zeigt eine Meßschaltung, die gemäß Patentanspruch 2 für eine zweiadrige Rohr- oder Kabelanlage vorgesehen ist. In jeder der beiden getrennt nebeneinander angeordneten Kabeladern sind ein Meßleiter $ML_1$ bzw. $ML_2$ und ein nichtisolierter, geerdeter Leiter $EL_1$ bzw. $EL_2$ angeordnet. Jeder Meßleiter, der mit einer feuchtigkeitsempfindlichen Isolierung versehen ist, ist am Anfang der Kabelanlage mit einem Meßwiderstand $R_{M1}$ bzw. $R_{M2}$ und am Kabelende mit einem Arbeitswiderstand $R_{A1}$ bzw. $R_{A2}$ beschaltet. Die beiden Arbeitswiderstände sind auf einen Belastungswiderstand $R_B$ geschaltet, der seinerseits mit dem Erdleiter $EL_1$ verbunden ist. Gleichzeitig ist der Erdleiter $EL_2$ der zweiten Kabelader am Anfang und am Ende der Kabelanlage mit dem Erdleiter $EL_1$ verbunden. - Die beiden Meßwiderstände $R_{M1}$ und $R_{M2}$ sind an den einen Pol einer Spannungsquelle U, die beiden nichtisolierten, geerdeten Leiter $EL_1$ und $EL_2$ an den anderen Pol dieser Spannungsquelle gelegt. Alternativ kann am Anfang der Kabelanlage eine Meßschaltung gemäß Figur 8 gewählt werden.

Figur 1 zeigt eine Meßschaltung für eine dreiadrige Kabelanlage, bei der jede der drei parallel angeordneten Kabeladern die Länge L aufweist. Im Schirmbereich jeder Kabelader sind ein Meßleiter ML und ein geerdeter Rückleiter EL angeordnet. Am Anfang und am Ende der Kabelanlage ist jeweils ein Überspannungsableiter ÜA zwischen dem Meßleiter und den geerdeten Leiter geschaltet.

Am Ende der Kabelanlage ist jeder Meßleiter ML mit einem Abschlußwiderstand $R_A$ beschaltet. Die Abschlußwiderstände $R_{A1}$ bis $R_{A3}$ sind auf einem gemeinsamen Belastungswiderstand $R_B$ geschaltet, der seinerseits geerdet und mit den geerdenten Leitern $EL_1$ bis $EL_3$ der Meßschleifen verbunden ist. Am Anfang der Kabelanlage ist jeder Meßleiter ML mit einem Meßwiderstand $R_{M1}$, bzw. $R_{M2}$, bzw. $R_{M3}$ beschaltet. Die Meßwiderstände $R_{M1}$ bis $R_{M3}$ sind gemeinsam über die Wicklung eines Relais A an den negativen Pol einer Gleichspannungsquelle geschaltet, deren positiver Pol mit den geerdeten Leitern der Meßschleifen verbunden ist. Dabei sind die Meßwiderstände und die Meßspannungsquelle in einem Meßgerätegehäuse GM angeordnet, das auch die nicht näher bezeichneten Meßgeräte zum Erfassen der durch die Meßwiderstände fließenden Ströme $I_1$, $I_2$ und $I_3$ aufnimmt. Weiterhin enthält das Gehäuse nicht näher dargestellte elektronische Einrichtungen zur Auswertung der gemessenen Ströme.

Wenn die Spannung der Spannungsquelle U nicht aktiviert ist, überbrückt der Ruhekontakt a die Spannungsquelle U und schaltet damit die Meßwiderstände $R_M$ gegen Erde. Dadurch sind die Meßleiter jederzeit elektrisch so abgeschlossen, daß bei allen Betriebszuständen keine gefährlichen Spannungen zwischen den Meßleitern ML und dem Kabelschirm auftreten können. Im Rahmen dieser Schutzmaßnahme begrenzt der ohmsche Widerstand jedes Meßleiters zusammen mit den angeschalteten Widerständen den induzierten Strom. Durch Wahl der Abschlußwiderstände $R_A$ auf maximal 20 % des Widerstandes des einzelnen Meßleiters beträgt die Wechselspannung am Abschlußwiderstand ebenfall nur ca. 20 % der induzierten Spannung. Mit Hilfe von zusätzlichen induktiven Widerständen können die Wechselspannungen an den Meßwiderständen noch wirksamer reduziert werden. Weiterhin besteht die Möglichkeit, am Anfang und am Ende der Kabelstrecke die Meßleiter unmittelbar nach dem Heraustreten aus dem Kabelmantel noch im Anschlußbereich von Endverschlüssen, Schaltereinführungen oder Kabelsteckern zwischen dem Überspannungsableiter und dem Meßwiderstand über einen Relaiskontakt, der im Fehlerfall von der Meßeinrichtung angesteuert wird, zu erden, um nach Auftreten und Orten eines Fehlers einen Stromfluß über die Schadensstelle zu unterbinden.

Gemäß Figur 2 treibt eine an die Meßschleife angelegte Meßspannung U Ströme $I_1$, $I_2$ und $I_3$ durch die jeweiligen Meßleiter. Zur Vereinfachung des Schaltungsaufwandes empfiehlt es sich, alle Sensorwiderstände und alle Abschlußwiderstände gleich groß zu wählen. Dann sind bei nicht beschädigten Kabelmänteln die drei gemessenen Ströme innerhalb eines Tolerenzbandes gleich groß. Bei Auftreten einer Schadensstelle gemäß Fig. 3 an dem Ort $F_1$ dringt in den Schirmbereich des beschädigten Kabels Wasser ein, wodurch der Isolationswiderstand zwischen dem Meßleiter und dem geerdeten Leiter einer Meßschleife erheblich verkleinert wird. Der reduzierte Widerstand ist schaltungstechnisch durch den Widerstand $R_{\ddot{U}}$ berücksichtigt. Durch diesen Übergangswiderstand wird der Stromfluß innerhalb der Schaltung gemäß Figur 2 verändert; das bedeutet bei einem Fehler in der Kabelader 1, daß der Strom $I_1$ größer ist als die Ströme $I_2$ und $I_3$, die weiterhin untereinander gleich sind. Unter Berücksichtigung der bekannten Größen der Schaltungswiderstände kann der Fehlerort in der Kabelader 1, gemessen vom Kabelanfang, mit nachfolgender Gleichung ermittelt werden, wenn der Strom $I_1$ um mindestens 5 % größer ist als die Ströme $I_2$ und $I_3$:

$$L_1 = \frac{R_B \bullet R_M (I_2 - I_1) - (L \bullet R_s{}' + R_A) \bullet [(U - (R_M + R_A + L \bullet R_s{}') \bullet I_2) - R_B \bullet (2I_2 + I_3)]}{R_s{}' \bullet [R_B \bullet (I_1 + I_2 + I_3) - U + (R_M + R_A + L \bullet R_s{}') \bullet I_2]}$$

Diese Rechenoperation kann von einem Mikrocomputer ausgeführt und das Ergebnis zur Anzeige gebracht werden.

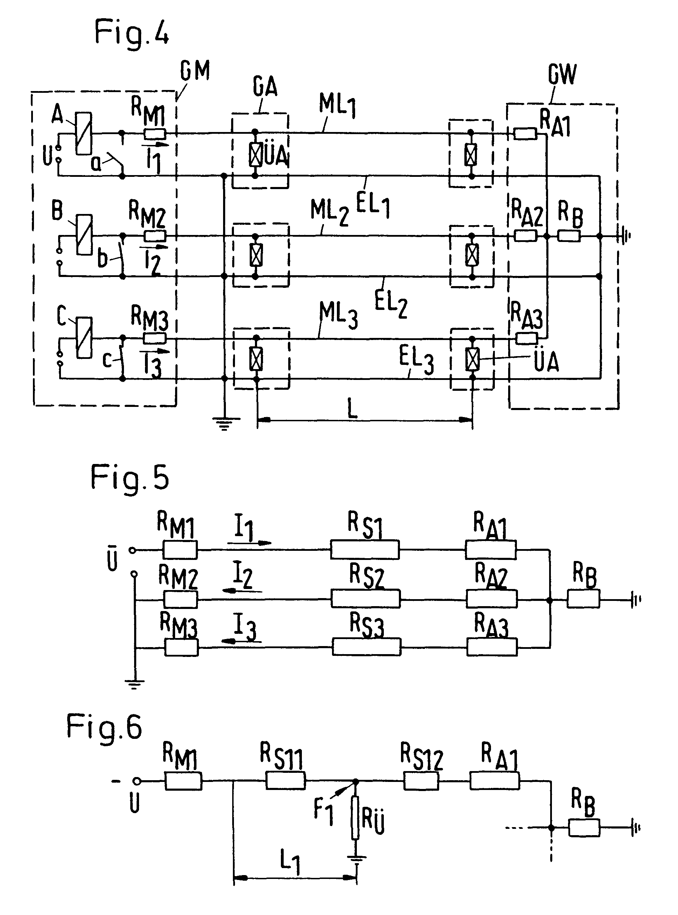

Die Meßschaltung gemäß Figur 4 unterscheidet sich von der Meßschaltung nach Figur 1 nur durch die Beschaltung am Anfang der Kabelstrecke. Innerhalb des Meßgerätes GM ist dabei dem Meßleiter und dem geerdeten Rückleiter jeder Meßschleife ein eigener Spannungsabgriff zugeordnet, wobei zwischen dem jeweiligen Meßwiderstand $R_M$ und dem Spannungsabgriff ein Relais A bzw. B bzw. C angeordnet ist, dessen Ruhekontakt a bzw. b bzw. c normalerweise den Meßwiderstand erdet. Sofern an die jeweilige Meßschleife eine Spannung U angelegt wird, öffnet der Ruhekontakt und über den Meßwiderstand wird ein Strom in die Meßschaltung eingespeist. Bei Anlegen einer Spannung U an den Spannungsabgriff des Meßleiters $ML_1$ werden die Meßleiter $ML_2$ und $ML_3$ vom Kabelende her mit einer Spannung beaufschlagt, wie es aus dem vereinfachten Ersatzschaltbild gemäß Figur 5 zu erkennen ist. Demzufolge fließen auch Ströme durch die Meßwiderstände $R_{M2}$ und $R_{M3}$. Im Falle eines Wassereinbruches in eine Kabelader gemäß Figur 6 werden an der Schadensstelle $F_1$ der Meßleiter $ML_1$ und der geerdete Rückleiter $EL_1$ der ersten Meßschleife über einen Übergangswiderstand $R_{\ddot{U}}$ verbunden, wodurch die Ströme durch die Meßwiderstände $RM_1$, $RM_2$ und $RM_3$ in ihrem Verhältnis zueinander verändert werden.

Für diese Schaltung errechnet sich die Lage des Fehlerortes aus der nachfolgenden Gleichung, wobei davon ausgegangen wird, daß die Meßspannung an der Meßschleife anliegt, deren Kabelader den Wassereinbruch aufweist:

$$L_1 = \frac{U - R_M \bullet \left( I_1 + \dfrac{R_M + R_s{}' \bullet L + R_A + R_B}{R_B} \bullet I_2 + I_3 \right) + }{\phantom{xxx}}$$

$$\frac{\phantom{xxx}}{(R_M + R_s{}' \bullet L + R_B)\left( \dfrac{R_M + R_s{}' \bullet L + R_A + 2R_B}{R_B} \bullet I_2 + I_3 \right)}{R_s{}' \bullet (I_1 + \dfrac{R_M + R_s{}' \bullet L + R_A + R_B}{R_B} \bullet I_2 + I_3)}$$

Mit zwei Zahlenbeispielen soll abschließend die praktische Auslegung der beiden Schaltungen demonstriert werden. Unter der Annahme, daß bei der Kabelanlage gemäß Figur 1

L = 1000 m,
$R_B$ = 560 Ohm,
$R_A$ = $R_{A1}$ = $R_{A2}$ = $R_{A3}$ = 330 Ohm,

$R_M$ = $R_{M1}$ = $R_{M2}$ = $R_{M3}$ = 1000 Ohm,
$R_s'$ = 6,6 Ohm/m, d.h. $R_S$ = $R_{S1}$ = $R_{S2}$ = $R_{S3}$ = 6,6 kOhm
U = 6,126 V
$I_1$ = 1,418 x $10^{-3}$A
$I_2$ = 0,744 x $10^{-3}$A und
$I_3$ = 0,744 x $10^{-3}$A

betragen, beträgt der Abstand $L_1$ des Fehlerortes vom Anfang der Kabelstrecke 501,3 m, wobei der Fehler in der Kabelader 1 vorliegt.

Unter der Annahme, daß bei einer Schaltung gemäß Figur 4

L = 1000 m,
$R_B$ = 100 Ohm,
$R_A$ = $R_{A1}$ = $R_{A2}$ = $R_{A3}$ = 100 Ohm,
$R_M$ = $R_{M1}$ = $R_{M2}$ = $R_{M3}$ = 100 Ohm,
$R_S'$ = 1 Ohm/m, d.h. $R_S$ = $R_{S1}$ = $R_{S2}$ = $R_{S3}$ = 1 kOhm,
U = 10 V,
$I_1$ = 12,00 x $10^{-3}$A,
$I_2$ = 0.443 x $10^{-3}$ A und
$I_3$ = 0,443 x $10^{-3}$A

betragen, beträgt der Abstand $L_1$ des Fehlerortes vom Kabelanfang 249,4 m, wobei die Fehlerstelle ebenfalls in der Kabelader 1 liegt.

Zur Vervollkommnung der Schaltungén gemäß Figur 1 und 2 können am Anfang und Ende jeder Kabelstrecke zwischen dem jeweiligen Meßleiter und dem geerdeten Leiter bzw. dem Kabelschirm Schalter angeordnet sein. Diese Schalter werden im Falle eines detektierten Wassereinbruches in der betreffenden Kabelader automatisch nach Abschluß der Ortungsmessung geschlossen. Dadurch werden das Fließen von induzierten Wechselströmen über die Fehlerstelle und eine daraus resultierende Erwärmung vermieden. Bei den hierzu verwendeten Schaltern kann es sich beispielsweise um Kontakte von Relais handeln, deren Spulen sich jeweils in den Stromkreisen der Wassersensoren befinden. Die Spulen und Kontakte sind dabei zu den Stromkreisen zyklisch vertauscht. Wenn beispielsweise ein Mantelfehler in der Kabelader 1 auftritt, wird der Meßleiter des Wassersensors der Kabelader 2 mit einer Spannung beaufschlagt, die das im Stromkreis dieses Wassersensors befindliche Relais erregt; dessen Arbeitskontakt erdet in der fehlerbehafteten Kabelader 1 den Meßleiter. - Anstelle der vorgenannten Schalter oder parallel dazu kann auch jeweils ein Kondensator angeordnet sein, der den Meßleiter ständig wechselstrommäßig gegen Erde schaltet. Während der Ortungsmessung wird dadurch ein gegebenenfalls über die Schadensstelle fließender Wechselstrom reduziert.

Alternativ zu der Meßschaltung gemäß Figur 5 kann am Anfang der Kabelanlage eine Verknüpfung der Meßleiter und der geerdeten, nichtisolierten Leiter vorgesehen werden, wie sie in Figur 11 dargestellt ist. Demzufolge kann man zwei Meßwiderstände gemeinsam mit dem einen Pol der Spannungsquelle und den dritten Meßwiderstand und die nichtisolierten, geerdeten Leiter der drei Kabeladern mit dem anderen Pol der Spannungsquelle verbinden. Dabei kann selbstverständlich auch eine Zuordnung gewählt werden, wie sie in Figur 12 dargestellt ist.

Bei einer Schaltung gemäß Figur 11 bzw. Figur 12 errechnet sich der Fehlerort nach einer anderen Gleichung als für die Schaltung gemäß den Figuren 2 und 5, jedoch ergibt'sich diese Gleichung aus den einschlägig bekannten Rechenoperationen zur Erfassung eines Widerstandsnetzwerkes.

## Patentansprüche

1. Meßschaltung zum Erfassen und Orten eines Wassereinbruches an einem Rohr oder einem elektrischen Kabel, unter dessen Mantel ein mit einer feuchtigkeitsempfindlichen Isolierung versehener elektrischer Meßleiter (ML) und ein nichtisolierter Leiter (EL) angeordnet sind und bei dem dem Meßleiter (ML) und dem nichtisolierten Leiter (EL) ein gegenüber dem Meßleiter (ML) feuchtigkeitsunempfindlich isolierter Hilfsleiter (HL) zugeordnet ist, wobei der Meßleiter (ML) und der nichtisolierte Leiter (EL) einen Wassersensor bilden, der Meßleiter (ML) und der Hilfsleiter (HL) am Ende des Kabels oder Rohres miteinander verbunden sind und der Meßleiter (ML), der Hilfsleiter (HL) und der nichtisolierte Leiter (EL) am Anfang des Rohres oder Kabels an eine Meßanordnung angeschlossen sind,
**dadurch gekennzeichnet, daß**
der Meßleiter (ML) und der Hilfsleiter (HL) am Ende des Rohres oder Kabels jeweils über einen Abschlußwiderstand ($R_A$)auf einen gemeinsamen Belastungswiderstand ($R_B$) geschaltet sind, der seinerseits mit dem nichtisolierten Leiter (EL) verbunden ist, und daß

- am Anfang des Rohres oder Kabels der Meßleiter (ML) und der Hilfsleiter (HL) jeweils mit einem Meßwiderstand ($R_M$) beschaltet
- und die beiden Meßwiderstände ($R_M$) und der nichtisolierte Leiter (EL) in beliebiger Kombination mit den beiden Polen einer Spannungsquelle (U) verbunden sind (Fig. 7, Fig. 8)
- oder beide Meßwiderstände ($R_M$) mit dem nichtisolierten Leiter (EL) verbunden sind
  und der Meßleiter ($ML_{11}$) und der nichtisolierte Leiter ($EL_1$) innerhalb des Rohres oder Kabels die beiden Pole einer durch Feuchtigkeitseinwirkung aktivierbaren Spannungsquelle ($U_i$)bilden (Fig.9).

2. Meßschaltung nach Anspruch 1,
   **dadurch gekennzeichnet, daß**
   der Hilfsleiter in einem parallel zum erstgenannten Rohr oder Kabel angeordneten zweiten Kabel oder Rohr angeordnet und als Meßleiter ($ML_2$)mit einer feuchtigkeitsempfindlichen Isolierung ausgebildet ist
   und daß in diesem zweiten Rohr oder Kabel ebenfalls ein nichtisolierter Leiter ($EL_2$)angeordnet ist, der am Anfang und am Ende des zweiten Rohres oder Kabels mit dem nichtisolierten Leiter ($EL_1$)des erstgenannten Rohres oder Kabels verbunden ist (Fig. 10).

3. Meßschaltung nach Anspruch 2,
   **dadurch gekennzeichnet, daß**
   parallel zu dem ersten und dem zweiten Kabel oder Rohr ein drittes Rohr oder Kabel angeordnet ist, unter dessen Mantel ein feuchtigkeitsempfindlicher Meßleiter ($ML_3$) und ein nichtisolierter Leiter ($EL_3$) angeordnet sind,
   daß der dritte Meßleiter am Anfang des Rohres oder Kabels ebenfalls mit einem Meßwiderstand ($R_{M3}$) beschaltet und am Ende des Rohres oder Kabels ebenfalls mit einem Abschlußwiderstand ($R_{A3}$) beschaltet und dieser Abschlußwiderstand auf den gemeinsamen Belastungswiderstand ($R_B$) der beiden erstgenannten Rohre oder Kabel geschaltet ist, wobei der nichtisolierte Leiter ($EL_3$) am Anfang und am Ende des Rohres oder Kabels mit den nichtisolierten Leitern ($EL_1$, $EL_2$) der beiden anderen Rohre oder Kabel verbunden ist,
   und daß der Meßwiderstand ($R_M$) des dritten Meßleiters ebenfalls mit einem der beiden Pole der Spannungsquelle (U) bzw. mit dem nichtisolierten Leiter (EL) verbunden ist (Fig. 1, Fig. 4).

4. Meßschaltung nach einem der Ansprüche 1 bis 3,
   **dadurch gekennzeichnet,**
   **daß** der bzw. die nichtisolierten Leiter (EL) am Anfang und/oder am Ende des Rohres oder Kabels bzw. der Rohr- oder Kabelanlage geerdet sind (Fig. 1 bis 6).

5. Meßschaltung nach einem der Ansprüche 1 bis 4,
   **dadurch gekennzeichnet,**
   **daß** jeder Meßwiderstand ($R_M$) einerseits mittels eines Ruhekontaktes (a, b, c) eines Relais (A, B, C) gegen den nichtisolierten Leiter (EL) des jeweiligen Wassersensors und andererseits unter Zwischenschaltung des Relais (A, B, C) gegen einen Spannungseinspeisungspunkt (U) geschaltet ist (Fig. 4).

6. Meßschaltung nach Anspruch 5 für eine mehradrige Kabelanlage
   **dadurch gekennzeichnet,**
   **daß** am Anfang und am Ende jeder Kabelader zwischen dem Meßleiter (ML) und dem nichtisolierten Leiter (EL) jedes Wassersensors ein Überspannungsableiter (ÜA) geschaltet ist (Fig.1, Fig. 4).

7. Meßschaltung nach Anspruch 5, bei der alle Meßwiderstände gemeinsam an den einen Pol der Spannungsquelle geschaltet sind,
   **dadurch gekennzeichnet,**
   **daß** zwischen den Meßwiderständen ($R_M$) und der Spannungsquelle (U) ein Relais (A)angeordnet ist und daß ein Ruhekontakt (a) dieses Relais (A) die Meßwiderstände ($R_M$) mit den nichtisolierten Leitern (EL) der Wassersensoren verbindet (Fig. 1).

8. Meßschaltung nach einem der Ansprüche 1 bis 3,
   bei der der Meßleiter und der nichtisolierte Leiter innerhalb des Rohres oder Kabels bzw. innerhalb der Rohre oder Kabel die beiden Pole einer durch Feuchtigkeitseinwirkung aktivierbaren Spannungsquelle bilden,
   **dadurch gekennzeichnet, daß** der Meßleiter ($ML_{11}$) und der nichtisolierte Leiter ($EL_1$) aus dem gleichen elektrisch gut leitenden Metall bestehen und daß der Meßleiter ($ML_{11}$) mit einer maximal etwa 100 µm dicken Schicht aus einem Metall versehen ist, dessen elektrochemische Spannung kleiner ist als die des Leitermaterials.

**9.** Meßschaltung nach Anspruch 8,
**dadurch gekennzeichnet, daß** der Meßleiter ($ML_{11}$) und der nichtisolierte Leiter ($EL_1$) aus Kupfer bestehen und daß die Beschichtung des Meßleiters aus Zink besteht.

**10.** Meßschaltung nach Anspruch 8 oder 9,
**dadurch gekennzeichnet, daß** der Meßleiter ($ML_{11}$) mit einem Geflecht aus isolierenden Fäden versehen ist.

## Claims

**1.** Measurement circuit for detecting and locating a water ingress point on a pipe or an electrical cable under whose casing an electrical measurement conductor (ML), which is provided with moisture-sensitive insulation, and a non-insulated conductor (EL) are arranged, and in the case of which an auxiliary conductor (HL), which is insulated in a moisture-insensitive manner with respect to the measurement conductor (ML), is assigned to the measurement conductor (ML) and to the non-insulated conductor (EL), the measurement conductor (ML) and the non-insulated conductor (EL) forming a water sensor, the measurement conductor (ML) and the auxiliary conductor (HL) being connected to one another at the end of the cable or pipe, and the measurement conductor (ML), the auxiliary conductor (HL) and the non-insulated conductor (EL) being connected at the start of the pipe or cable to a measurement arrangement,
**characterized in that**
the measurement conductor (ML) and the auxiliary conductor (HL) are connected at the end of the pipe or cable, in each case via a terminating resistor ($R_A$), to a common load resistor ($R_B$) which, for its part, is connected to the non-insulated conductor (EL), and **in that**

- at the start of the pipe or cable, the measurement conductor (ML) and the auxiliary conductor (HL) are each connected to a measurement resistor ($R_M$)
- and the two measurement resistors ($R_M$) and the non-insulated conductor (EL) are connected in any desired combination to the two poles of a voltage source (U) (Fig. 7, Fig. 8)
- or both measurement resistors ($R_M$) are connected to the non-insulated conductor (EL) and the measurement conductor ($ML_{11}$) and the non-insulated conductor ($EL_1$) within the pipe or cable form the two poles of a voltage source ($U_i$) which can be activated by the influence of moisture (Fig. 9).

**2.** Measurement circuit according to Claim 1,
**characterized in that**
the auxiliary conductor is arranged in a second cable or pipe, which is arranged parallel to the first-mentioned pipe or cable, and is designed as a measurement conductor ($ML_2$) with moisture-sensitive insulation,
and **in that** a non-insulated conductor ($EL_2$) is likewise arranged in this second pipe or cable and is connected at the start and at the end of the second pipe or cable to the non-insulated conductor ($EL_1$) of the first-mentioned pipe or cable (Fig. 10).

**3.** Measurement circuit according to Claim 2,
**characterized in that**
a third pipe or cable is arranged parallel to the first and the second cable or pipe, under the casing of which third pipe or cable a moisture-sensitive measurement conductor ($ML_3$) and a non-insulated conductor ($EL_3$) are arranged,
**in that** the third measurement conductor is likewise connected at the start of the pipe or cable to a measurement resistor ($R_{M3}$) and is likewise connected at the end of the pipe or cable to a terminating resistor ($R_{A3}$), and this terminating resistor is connected to the common load resistor ($R_B$) of the two first-mentioned pipes or cables, the non-insulated conductor ($EL_3$) being connected at the start and at the end of the pipe or cable to the non-insulated conductors ($EL_1$, $EL_2$) of the two other pipes or cables,
and **in that** the measurement resistor ($R_M$) of the third measurement conductor is likewise connected to one of the two poles of the voltage source (U) or to the non-insulated conductor (EL) (Fig. 1, Fig. 4).

**4.** Measurement circuit according to one of Claims 1 to 3,
**characterized**
**in that** the non-insulated conductor or conductors (EL) is or are earthed at the start and/or at the end of the pipe or cable or of the pipe or cable system (Figs. 1 to 6).

5. Measurement circuit according to one of Claims 1 to 4, **characterized in that** each measurement resistor ($R_M$) is connected on one side by means of a normally-closed contact (a, b, c) of a relay (A, B, C) to the non-insulated conductor (EL) of the respective water sensor, and on the other side, with the interposition of the relay (A, B, C), to a voltage supply point (U) (Fig. 4).

6. Measurement circuit according to Claim 5 for a multi-core cable system **characterized in that** an overvoltage suppressor (ÜA) is connected at the start and at the end of each cable core, between the measurement conductor (ML) and the non-insulated conductor (EL) of each water sensor (Fig. 1, Fig. 4).

7. Measurement circuit according to Claim 5, in which all the measurement resistors are jointly connected to one pole of the voltage source, **characterized in that** a relay (A) is arranged between the measurement resistors ($R_M$) and the voltage source (U), and in that a normally-closed contact (A) of this relay (A) connects the measurement resistors ($R_M$) to the non-insulated conductors (EL) of the water sensors (Fig. 1).

8. Measurement circuit according to one of Claims 1 to 3, in which the measurement conductor and the non-insulated conductor within the pipe or cable or within the pipes or cables form the two poles of a voltage source which can be activated by the influence of moisture, **characterized in that** the measurement conductor ($ML_{11}$) and the non-insulated conductor ($EL_1$) are composed of the same electrically highly conductive metal, and **in that** the measurement conductor ($ML_{11}$) is provided with a coating which is a maximum of about 100 µm thick and is composed of a metal whose electrochemical voltage is lower than that of the conductor material.

9. Measurement circuit according to Claim 8, **characterized in that** the measurement conductor ($ML_{11}$) and the non-insulated conductor ($EL_1$) are composed of copper, and **in that** the coating of the measurement conductor is composed of zinc.

10. Measurement circuit according to Claim 8 or 9, **characterized in that** the measurement conductor ($ML_{11}$) is provided with a mesh composed of insulating threads.


**Revendications**

1. Circuit de mesure pour la détection et la localisation d'une entrée d'eau sur un tuyau ou un câble électrique sous l'enveloppe duquel sont disposés un conducteur de mesure (ML) électrique muni d'une isolation sensible à l'humidité et un conducteur non isolé (EL), un conducteur auxiliaire (HL) isolé de façon insensible à l'humidité par rapport au conducteur de mesure (ML) étant associé au conducteur de mesure (ML) et au conducteur non isolé (EL), le conducteur de mesure (ML) et le conducteur non isolé (EL) formant un détecteur d'eau, le conducteur de mesure (ML) et le conducteur auxiliaire (HL) étant reliés entre eux à la fin du tuyau ou câble et le conducteur de mesure (ML), le conducteur auxiliaire (HL) et le conducteur non isolé (EL) étant raccordés au début du tuyau ou câble à un dispositif de mesure, **caractérisé par le fait que** le conducteur de mesure (ML) et le conducteur auxiliaire (HL) sont branchés à la fin du tuyau ou câble chacun par une résistance terminale ($R_A$) sur une résistance de charge ($R_B$) commune qui est à son tour reliée au conducteur non isolé (EL), et que

   - au début du tuyau ou câble le conducteur de mesure (ML) et le conducteur auxiliaire (HL) comportent chacun une résistance de mesure ($R_M$)
   - et les deux résistances de mesure ($R_M$) et le conducteur non isolé (EL) sont reliés en combinaison quelconque aux deux pôles d'une source de tension (figure 7, figure 8)
   - ou les deux résistances de mesure ($R_M$) sont reliées au conducteur non isolé (EL) et le conducteur de mesure ($ML_{11}$) et le conducteur non isolé ($EL_1$) forment à l'intérieur du tuyau ou câble les deux pôles d'une source de

tension ($U_i$) activable par l'action d'humidité (figure 9).

2.  Circuit de mesure selon la revendication 1, **caractérisé par le fait que** le conducteur auxiliaire est disposé dans un second tuyau ou câble disposé parallèlement audit premier tuyau ou câble et est réalisé sous forme de conducteur de mesure ($ML_2$) avec une isolation sensible à l'humidité et que dans ce second tuyau ou câble est disposé également un conducteur non isolé ($EL_2$) qui est relié au début et à la fin du second tuyau ou câble au conducteur non isolé ($EL_1$) dudit premier tuyau ou câble (figure 10).

3.  Circuit de mesure selon la revendication 2, **caractérisé par le fait qu'**un troisième tuyau ou câble sous l'enveloppe duquel sont disposés un conducteur de mesure ($ML_3$) sensible à l'humidité et un conducteur non isolé ($EL_3$) est disposé parallèlement au premier et au second tuyaux ou câbles, que le troisième conducteur de mesure comporte également une résistance de mesure ($R_{M3}$) au début du tuyau ou câble et une résistance terminale ($R_{A3}$) à la fin du tuyau ou câble et cette résistance terminale est branchée sur la résistance de charge ($R_B$) commune des deux tuyaux ou câbles mentionnés en premier, le conducteur non isolé ($EL_3$) étant relié au début et à la fin du tuyau ou câble aux conducteurs non isolés ($EL_1$, $EL_2$) des deux autres tuyaux ou câbles, et que la résistance de mesure ($R_M$) du troisième conducteur de mesure est également reliée à l'un des deux pôles de la source de tension ($U$) ou au conducteur non isolé ($EL$) (figure 1, figure 4).

4.  Circuit de mesure selon l'une des revendications 1 à 3, **caractérisé par le fait que** le ou les conducteurs non isolés ($EL$) sont mis à la terre au début et/ou à la fin du tuyau ou câble ou de l'installation de tuyau ou de câble (figures 1 à 6).

5.  Circuit de mesure selon l'une des revendications 1 à 4, **caractérisé par le fait que** chaque résistance de mesure ($R_M$) est branchée d'une part à l'aide d'un contact repos (a, b, c) d'un relais (A, B, C) sur le conducteur non isolé ($EL$) du détecteur d'eau respectif et d'autre part par l'intermédiaire du relais (A, B, C) sur un point d'injection de tension ($U$).

6.  Circuit de mesure selon la revendication 5 pour une installation de câble à plusieurs brins, **caractérisé par le fait qu'**un dérivateur de surtension (ÜA) est monté au début et à la fin de chaque brin de câble entre le conducteur de mesure (ML) et le conducteur non isolé (EL) de chaque détecteur d'eau (figure 1, figure 4).

7.  Circuit de mesure selon la revendication 5, dans lequel toutes les résistances de mesure sont branchées ensemble sur l'un des pôles de la source de tension, **caractérisé par le fait qu'**un relais (A) est disposé entre les résistances de mesure ($R_M$) et la source de tension ($U$) et qu'un contact repos (a) de ce relais (A) relie les résistances de mesure ($R_M$) aux conducteurs non isolés (EL) des détecteurs d'eau (figure 1).

8.  Circuit de mesure selon l'une des revendications 1 à 3, dans lequel le conducteur de mesure et le conducteur non isolé à l'intérieur du tuyau ou câble ou à l'intérieur des tuyaux ou câbles forment les deux pôles d'une source de tension activable par l'action d'humidité, **caractérisé par le fait que** le conducteur de mesure ($ML_{11}$) et le conducteur non isolé ($EL_{11}$) sont constitués par le même métal bon conducteur électrique et que le conducteur de mesure ($ML_{11}$) est muni d'une couche d'une épaisseur maximale d'environ 100μm en un métal dont le potentiel électrochimique est plus faible que celui du métal du conducteur.

9.  Circuit de mesure selon la revendication 8, **caractérisé par le fait que** le conducteur de mesure ($ML_{11}$) et le conducteur non isolé ($EL_1$) sont en cuivre et que la couche de revêtement du conducteur de mesure est en zinc.

10. Circuit de mesure selon la revendication 8 ou 9, **caractérisé par le fait que** le conducteur de mesure ($ML_{11}$) est entouré de fils isolants entrelacés.

## Fig.1

## Fig.2

## Fig.3

## Fig.4

## Fig.5

## Fig.6

Fig.7

Fig.8

Fig.9

Fig.10

Fig.11

Fig.12